# EUROPEAN PATENT APPLICATION

(11) **EP 3 473 752 A1**
(43) Date of publication of application: **24.04.2019**
(21) Application number: 17382704.9
(22) Date of filing: 23.10.2017
(51) Int. Cl.: D01F 9/127, H01G 9/20

(54) **CARBON NANOTUBE-BASED MEMBRANE FOR SOLAR CELLS**

(71) Applicant: Fundación Imdea Materiales, 28938 Getafe - Madrid (ES)
(72) Inventor: COSTA RIQUELME, Rubén Darío, E-28938 Getafe - Madrid (ES); VILATELA GARCÍA, Juan José, E-28938 Getafe, Madrid (ES); MONREAL BERNAL, Alfonso, E-28938 Getafe - Madrid (ES)
(74) Representative: ABG Intellectual Property, S.L.

(57) **Abstract**

The present invention relates to a membrane suitable for dye-sensitized solar cells comprising porous carbon nanotube-based fibers, and an electrolyte confined within the pores of said fibers, as well as to a dye-sensitizer solar cell comprising said membrane.

## Description

### Technical field

The present invention relates to the field of solar cells and, more particularly, to the field of dye-sensitized solar cells (DSSCs).

### Background

As fossil fuel reserves run dry, methods for utilizing solar energy as electric energy are drawing more attention and efforts. The fields of solar cells present a solution for both environment preservation and the problem of energy shortage, while not generating pollutant substances. Particularly, dye-sensitized solar cells (DSSCs), surfaces of which are processed with solar cells by breaking down oxide particles into the nano size with the use of photosensitive dye molecules, generates electric energy as the dye absorbs light. It has the advantages that it is environmentally innocuous and the manufacturing process is simple.

Most DSSCs have a complex layered structure and comprise many components. In fact, a typical DSSC consists of a front-electrode (normally a transparent conductor of indium tin oxide, ITO, or fluorine-doped tin oxide, FTO), a mesoporous layer of TiO₂ as charge injection medium (photo-anode), a dye that harvests light and transfers charge to TiO₂, an electrolyte that enables diffusion of ions and regenerates oxidized dyes, a Pt counter-electrode that regenerates the electrolyte, and a current collector (normally ITO or FTO) to establish electrical contact with the counter-electrode material.

As consequence, the fabrication of a typical DSSC comprises many batch-process steps, typically: extensive cleaning of the front and current electrodes (ITO and FTO); preparation of the mesoporous photo-anode using a three-step procedure (deposition of a thin layer of TiO₂ from TiCl₄/HCl solution, deposition of a thick TiO₂ layer from a TiO₂ nanoparticle paste via screen-printing, doctor-blading, etc., and a sintering process at high temperatures); preparation of the Pt counter-electrode coating on ITO and/or FTO electrode with a H₂PtCl₆·6H₂O solution followed by sintering at high temperatures; the assembly of both electrodes using a thermoplastic glue; introduction of a solution and/or highly viscous electrolyte containing the redox couple in between both photo-anode and counter-electrode; and the final sealing of the device to avoid leakage of the electrolyte.

In addition, typical DSSCs use volatile liquid electrolytes which may lead to leakage and/or evaporation problems as well as limiting the outdoor applications thereof. Therefore, researchers utilize ionic liquids as electrolytes to manufacture non-volatile DSSCs. Nevertheless, the high viscosity of such ionic liquid may lower the photocurrent conversion efficiency and thus limit the application of such electrolyte in the solar cells.

Therefore, many efforts have been made to:
- develop solid-state DSSCs with enhanced ionic mobility in order to avoid electrolyte leakage and/or evaporation;
- to simplify the complex fabrication process;
- to reduce the number of components and to eliminate Pt, a costly precious metal, as counter-electrode;
- while preserving or improving the efficiency and stability of DSSCs.

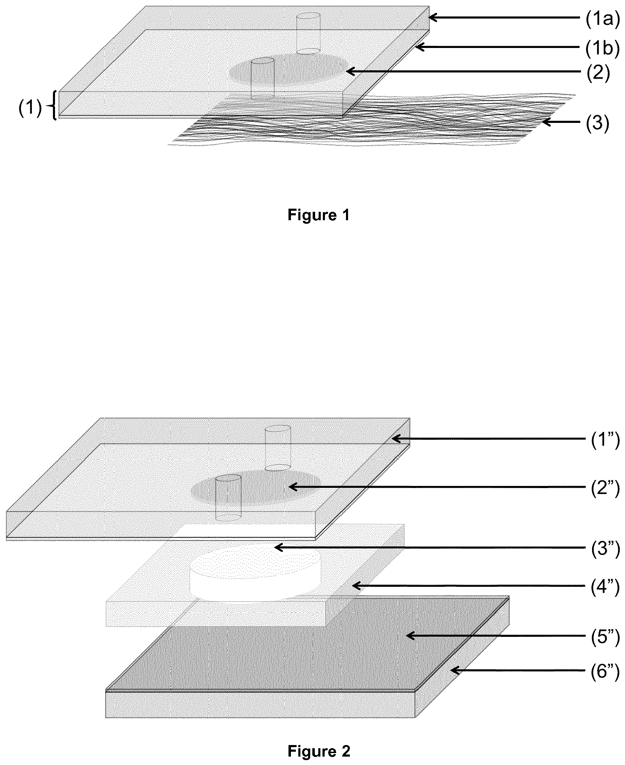

One of the approaches towards solid-state DSSCs is the use of polymer-based electrolytes and/or hole transport compounds that are typically cast onto the photo-anode (M.S. Su'ait et al. Solar Energy 2015; J. Wu et al. Chem. Rev. 2015). Concerning polymer-based electrolytes, the most promising strategy is the use of electrolyte membranes containing biopolymers (polysaccharides, chitosan, cellulose, polyurethane; Buraidah et al. Int. J. Photoenergy 2010; and F. Bella et al. Electrochim. Acta 2015) and/or building polymers (such PVdF-co-HFP in Sun et al. RSC Adv. 2017, 7, 20908-20918; and copolymer of polyvinyl-(acetate-co-methyl methacrylate) - [P(VA-co-MMA)]), that adsorb solution and/or gel-like electrolytes (H. Yang, et al. Sol. Energy Mater. Sol. Cells 2009; and C. Wang. et al. Electrochimica Acta 2013). Solar energy conversion efficiencies of around 7-9% have been achieved using a standard DSSC configuration (Figure 1), in which ITO/FTO electrodes cast with Pt nanoparticles were used. However, the membrane electrolyte only hosts the electrolyte allowing the diffusion of the redox species from the photo-anode (after dye regeneration) to the counter-electrode for electrolyte regeneration. It does not act as electrolyte regeneration platform nor as current collector.

Another approach towards solid-state DSSCs is to gellify the electrolytes using inorganic compounds (ceramics, TiO₂, SiO₂, ZnO, Al₂O₃ nanoparticles, *etc.*), nanocarbons (graphene, carbon nanotubes, carbon nanohorns, *etc.*), plasticizer, copolymerization, UV-cured and cross-linker polymers (M.S. Su'ait et al. Solar Energy 2015; and J. Wu et al. Chem. Rev. 2015). With regards to the use of nanocarbons (Lodermeyer; Energy Environmental Science 2014), the main assets are their high compatibility with any electrolyte and the enhanced ionic diffusivity of the electrolyte due to extended electron-transfer surface that assists the catalytic regeneration of the electrolyte. This leads to enhanced ionic mobility towards the counter-electrode, which is required to finalize the devices. However, the counter-electrode in these examples still consists of a Pt-cast FTO/ITO electrode.

Carbon nanotubes as counter-electrodes have also been proposed to replace Pt-cast electrodes due to its efficient catalytic regeneration of the electrolyte (P. Poudel et al. Nano Energy 2014; Prabakaran et al. RSC Adv., 2015; M. Cheng et al. Chem. Engineering J. 2017; and Arbab et al. J. Power Sources 2017). In this regard, there are numerous examples of work using a layer of carbon nanotubes as a counter-electrode (Briscoe et al. Adv. Mater. 2016; Wang et al. Energy Environ. Sci. 2012; Yun, A. et al. Adv. Mater. 2014; and Batmunkh et al. Small 2015). The state-of-art carbon nanotubes electrodes involves three major examples.

Firstly, Nam et al. (Scr. Mater. 2010), for example, demonstrated the use of an array of vertically oriented carbon nanotubes as counter-electrode in a DSSC and obtained ca. 10% efficiency without disclosing device stability. However, such cell still had the same number of components as conventional DSSCs. Furthermore, the fabrication of these electrodes involves a CVD technique that is expensive with respect to up-scaling process and the electrode is not mechanically stable. In addition, it is a cumbersome fabrication process and it is limited by the size of the carbon nanotubes array, typically in the range of a few cm².

A second family of examples is the fabrication of electrodes with a carbon nanotubes aggregate layer with and without the use of binders (Lee et al. ACS Appl. Mater. Interfaces 2009; and Ramasamy et al. Appl. Phys. Lett. 2007). These examples show devices with a conventional DSSC configuration, reaching efficiencies of around 6-7%. In addition, the fabrication of the carbon nanotubes aggregate layer is very cumbersome, requiring the stages of carbon nanotubes dispersion and casting (drop-casting, spray deposition, doctor-blading, *etc*.) onto a transparent conducting substrate (FTO/ITO). In addition, severe issues associated to the spontaneous peeling-off of the carbon nanotubes from the conducting electrode have been noted as the main reason for low device stability. Both limitations of this strategy in terms of cumbersome device fabrication and poor stability also apply to counter-electrodes based on other nanocarbons, such as graphene, carbon nanohorns and carbon black, (Lodermeyer et al. Adv. Energy Mater. 2017; Sing et al. Sci. Adv. Mater. 2016). In addition, there is a challenge in scaling-up these processes achieving uniformity with respect thickness and properties required for the adequate operation of a high-efficiency cell ensuring reproducibility.

The third approach involves the use of carbon nanotubes fibers as counter-electrodes using a conventional DSSC architecture (see for example CN105070508 (A)). Chen *et al.* proposed the use of carbon nanotubes fibers as counter-electrodes using solvent-based electrolytes. The device architecture involves intertwining a photo-anode wire and a carbon nanotubes fiber counter-electrode, and infiltrating the array with an electrolyte that connects both electrodes. This device featured low device efficiencies of around 3% (Chen et al. Nano Lett. 2012; and Sun et al. Energy Environ. Sci. 2015). The use of solid electrolytes in this device configuration has been scarcely investigated (Yan et al. Adv. Mater. Interfaces 2014; Sun et al. J. Mater. Chem. A 2014; and Li et al. ChemNanoMat 2015). In short, the device architecture is similar to that above-described using, however, a solid-state electrolyte that is introduced at high temperatures. At room temperature, this electrolyte solidifies, leading to a self-standing device featuring efficiencies up to 6%. Amongst limitations of this approach are the fact that it is specific to an intertwined geometry that is thus inherently incompatible with processing methods of widespread planar devices, and the use of solid-state electrolytes that are not stable under ambient conditions.

Numerous other materials besides nanocarbons have been explored as a replacement of Pt counter-electrodes (Yun et al. Adv. Mater. 2015). As state-of-the-art Pt-free counter-electrode in DSSCs, all examples followed a standard DSSC configuration using solid and/or liquid electrolytes placed in between the photo-anode and counter-electrode as well as the above-described sealing components. Shi et al (Scientific Reports 2015), for example, prepared small devices with 0.25 cm² active surface, where Pt was replaced with a film of aggregated CoNi₂S₄. Reported efficiency was 4.6%, comparable to control samples with Pt produced under nominally identical conditions. The CoNi₂S₄ are synthesized by a complex hydrothermal process and obtained only under a narrow window of chemical conditions. The full cell is assembled as a traditional one, with the CoNi₂S₄ film counter-electrode, using a plastic separator and injecting the electrolyte as a subsequent stage. An alternative approach has been to use a conducting polymer film that serves as both the counter-electrode and the current collector. This has been demonstrated with various polymers (PPy, PEDOT:PSS, *etc*). Veerender et al. [Organic Electronics, 2012, 13, 3032-3039], for example, obtained 3.5 % efficiency using poly-pyrrole membranes cast with 50 nm Au film as counter-electrode in a DSSC. In addition to the membrane, the cell contained a photo-anode, front-electrode, dye and a gel electrolyte. Other materials used to produce Pt-free and TCO-free counter-electrodes include TiC, WO, VN.

Therefore, despite the efforts disclosed in the above-mentioned state-of-art, none of them have been able to address the simplification of the device architecture and fabrication process of DSSCs.

Attempts to reduce the number of components of DSSC are disclosed for example in US 2013/125970. This document describes a counter electrode for DSSC which can take roles of a catalyst and an electrode at the same time and which comprises a porous membrane including a carbon-based material and platinum nanoparticles. However, the disclosed DSSC is not Pt-free. The method to produce the disclosed DSSC requires to produce the stacking (arrangement) of cell components and subsequent injection of electrolyte. Furthermore, the DSSC devices require a separator for their operation.

Therefore, there is still a need to develop a Pt-free DSSC with reduced number of components and without electrolyte leakage issues, which has good stability and efficiency, and a simple process for manufacturing them.

### Brief description of the invention

The authors of the present invention have developed a Pt-free membrane comprising fibers of carbon nanotubes and an electrolyte infiltrated within the pores of the fibers. The membrane of the present invention can be easily integrated within a DSSC, acting simultaneously as i) an electrolyte, regenerating the photoexcited dye, ii) counter-electrode, regenerating in a quasi-zero distance the oxidized electrolyte, and iii) current collector, driving the collected current to the external load. Therefore, the membrane of the present invention allows constructing a Pt-free DSSC with reduced number of components and wherein the electrolyte is confined within the pores of the carbon nanotube-based fabric and, thus, avoiding electrolyte leakage.

Therefore, a first aspect of the invention is directed to a membrane suitable for dye-sensitized solar cells comprising:
- porous carbon nanotube-based fibers, and
- an electrolyte confined within the pores of said fibers.

In a second aspect, the present invention is directed to a method (from now onwards method 1) for the preparation of the membrane as defined above, comprising the steps of:
a) providing porous carbon nanotube-based fibers;
b) converting the porous carbon nanotube-based fibers into a membrane;
c) immersing said membrane into an electrolyte solution so as the electrolyte is confined within the pores of the porous carbon nanotube-based fibers.

As explained above the membrane of the present invention can be easily integrated within a dye-sensitized solar cell reducing the number of needed components and significantly simplifying the device fabrication process while providing highly stable and efficient solar cells.

Therefore, a third aspect of the present invention is directed to a dye-sensitized solar cell comprising at least one membrane as defined above. Figure 1 shows a dye-sensitized solar cell according to the present invention.

Thus, in a particular embodiment, the dye-sensitized solar cell comprises:
a) a transparent conductive substrate (1);
b) a mesoporous semiconductor layer (2) provided on the transparent substrate (1), said mesoporous semiconductor layer (2) comprising a dye sensitizer; and
c) a membrane (3) as defined above, *i.e.,* a membrane comprising a porous carbon nanotube-based fibers and an electrolyte confined within the pores of said fibers, said membrane placed on the mesoporous semiconductor layer (2).

In a fourth aspect, the present invention is directed to a method (from now onwards method 2) of preparing a dye-sensitized solar cell comprising the steps of:
a) providing a transparent conductive substrate (1);
b) forming a mesoporous semiconductor layer (2) on the transparent conductive substrate (1);
c) adsorbing a dye sensitizer in the mesoporous semiconductor layer (2);
d) depositing a membrane (3) comprising a porous carbon nanotube-based fibers and an electrolyte confined within the pores of said fibers, on the mesoporous semiconductor layer (2).

Finally, as explained above, the dye-sensitized solar cell as defined above presents high efficiency compared to state-of-the-art DSSCs with traditional device architectures in which the electrolyte (liquid, gel-like, solid-state, and membrane-like) connects the photo-anode and the Pt-based and/or Pt-free counter-electrode.

Thus, the present invention also refers to the use of the dye-sensitized solar cell as defined above for converting solar energy into electric energy.

### Figures

**Figure 1****.** Schematic representation of a dye-sensitized solar cell (DSSC) according to the present invention.
**Figure 2****.** Schematic representation of a conventional DSSC.
**Figure 3****.** Scheme of a carbon nanotube membrane DSSC bearing two photoanodes.
**Figure 4****.** Current density-voltage graph of carbon nanotube membrane DSSCs under dark (dashed line) and 1sun AM1.5 illumination (solid line).
**Figure 5****.** Current density-voltage graph of Pt-based DSSCs under dark (dashed line) and 1sun AM1.5 illumination (solid line).
**Figure 6****.** Current-voltage graphs of carbon nanotube membrane DSSCs bearing two photoanodes upon front, back and front-back 1 sun AM1.5 illumination.

### Detailed description of the invention

Unless defined otherwise, all technical and scientific terms used herein have the same meaning as commonly understood to one of ordinary skill in the art to which this disclosure belongs.

As defined above, in a first aspect, the present invention refers to a membrane suitable for dye-sensitized solar cells, said membrane comprising:
- porous carbon nanotube-based fibers, and
- an electrolyte confined within the pores of said fibers.

The term "solar cell" (also known as "photovoltaic cell") refers to an electrical device that converts the energy of light directly into electricity by the photovoltaic effect. The term "dye-sensitized solar cell" (DSSC, DSC, DYSC or "Grätzel cell") refers to a type of solar cell belonging to the group of thin film solar cells (second generation solar cells that are made by depositing one or more thin layers, or thin film of a photovoltaic material on a substrate, such as glass, plastic or metal) and which is based on a semiconductor formed between a photo-sensitized anode and an electrolyte forming a photo-electrochemical system.

Figure 2 shows a typical dye-sensitized solar cell which comprises:
- a front-electrode (1 "), normally a transparent conductor made of ITO or FTO;
- a photo-anode, normally a mesoporous conductor layer (2") of TiO₂ that comprises a dye that harvests light and transfers charge to TiO₂;
- an electrolyte (3") that enables diffusion of ions and regenerates oxidized dyes;
- a sealant (4") to avoid electrolyte leakage;
- a Pt counter-electrode (5") that regenerates the electrolyte; and
- a current collector (6"), normally made of ITO or FTO, to establish electrical contact with the counter-electrode material (5").

In view of the above, a conventional DSSC, such as the one showed in Figure 2, typically operates through the following sequence of steps:
a) light is absorbed by the dye loaded in the mesoporous conductor layer (2") formed by a TiO₂ layer;
b) the dye transfer electric charge to the TiO₂ layer upon its oxidation;
c) charge is transported through the TiO₂ layer to the front-electrode (1") and extracted as current;
d) simultaneously with step (c), the electrolyte (3") regenerates the oxidized dye and the redox species of the electrolyte diffuse to a Pt counter-electrode (5");
e) the electrolyte (3") is regenerated (reduced) at the counter-electrode surface (5"); and
f) the current collector (6") at the counter-electrode closes the electrical circuit.

The membrane of the present invention when integrated in a DSSC is able to act simultaneously as electrolyte ((3") in Figure 2), counter-electrode ((5") in Figure 2) and current collector ((6") in Figure 2), reducing the number of components in the cell, and eliminating the need for Pt as counter-electrode material.

In addition, DSSCs usually require a membrane as separator to prevent physical contact between the photo-anode and the counter-electrode while permitting free-ion flow.

However, in the present invention, the term "membrane" relates to a material which is made at least of porous carbon nanotube-based fibers and an electrolyte confined within the pores of said fibers and which does not act as a simple physical barrier but also as current collector and counter-electrode in terms of conductivity and catalytic properties, and also as host for the electrolyte which is confined within the pores of the carbon nanotube-based fibers.

In a particular embodiment, the membrane of the invention has a thickness between 0.01 and 1000 microns.

In a preferred embodiment, the membrane of the present invention is in the form of a unidirectional nonwoven sheet of CNT fibres, preferably having a thickness between 1 and 10 microns.

In the context of the present invention, the term "carbon nanotube" refers to a structure made by rolling up a sheet of graphene into a cylinder. Depending on the rolling degree and the way the original graphene sheet is formed, carbon nanotubes of different diameter and internal geometry can be formed. Carbon nanotubes formed by rolling up of a single sheet forming the aforementioned cylinder, are called "single-walled" nanotubes. The carbon nanotubes formed by rolling up of more than one sheets with a structure that resembles a series of concentric cylinders, logically, of increasing diameters from the center to the periphery like Matryoshka dolls are called "multi-walled" nanotubes.

In a preferred embodiment, the carbon nanotubes used in the present invention are single-walled or multi-walled, more preferably multi-walled, even more preferably carbon nanotubes having between 2 and 5 graphitic layers of graphene.

In another preferred embodiment, the carbon nanotubes used in the present invention are nanotubes with high aspect ratio, preferably between 10 and 10000000, even more preferably between 100 and 10000000. The carbon nanotubes used in the present invention are also preferably highly graphitic.

In the context of the present invention, the term "carbon nanotube-based fiber" refers to a macroscopic array of agglomerated carbon nanotubes as defined above, where the fiber can be used as an individual filament, or as a flat film or sheet, or as a woven or non-woven fabric. By grouping carbon nanotubes as fibers their mechanical properties as well as their electrical conductivity are enhanced. In addition, the carbon nanotube-based fibers used in the present invention present porosity as a result of voids formed between the carbon nanotubes due to imperfect packing.

Therefore, in another preferred embodiment, the carbon nanotube-based fibers used in the present invention are fibers having a specific surface area between 50 and 2000 cm³/g.

The pores of the carbon nanotube-based fibers used in the present invention act as host for the electrolyte, i.e. the electrolyte is retained within the pores of the fibers, thus avoiding electrolyte leakage issues.

Electrolytes suitable to be confined into the pores of the carbon nanotube-based fibers are liquid, solid, or quasi-solid electrolytes.

In the context of the present invention, the term "liquid electrolyte" refers to electrolytes comprising at least a redox couple for regeneration of the oxidized dye, and a solvent, more particularly an organic solvent or water, for giving an environment for ions' dissolution and diffusion.

Non-limiting examples of redox couples suitable in the present invention are I⁻/I₂; Br⁻/Br ₂; SCN⁻/SCN₂; and SeCN-/SeCN₂; a metal complex such as ferrocyanide/ferricyanide complex, a ferrocene/ferricinium ion complex, a copper redox complex, or a cobalt redox complex; a sulfur compound such as sodium polysulfide or alkylthiol/alkyldisulfide; hydroquinone/quinone. In relation to the iodide (I⁻) metal iodides such as Lil, Nal, Kl, Csl and Cal₂; quaternary ammonium iodides such as tetralkylammonium iodide, pyridinium iodide and imidazolium iodide (for example methyl-hexyl-imidazolium iodide (MHIMI), 1-ethyl-3-methylimidazolium iodide (EMIMI) or 1-butyl-3-methylimidazolium iodide (BMIMI)) and the like can be used. In relation to the bromide (Br⁻) metal bromides such as LiBr, NaBr, KBr, CsBr and CaBr₂; quaternary ammonium bromides such tetralkylammonium bromide and pyridinium bromide bromide (for example methyl-hexyl-imidazolium bromide (MHIMBr), 1-ethyl-3-methylimidazolium bromide (EMIMBr) or 1-butyl-3-methylimidazolium bromide (BMIMBr)) and the like can be used. These electrolyte materials may be used either alone or in combination thereof.

It is preferred that the solvent is that having a low viscosity, high ionic mobility and sufficient ionic conductivity. Non-limiting examples of solvents suitable in the present invention are organic solvents, more preferably nitriles, such as acetonitrile (AcN), valeronitrile, glutarodinitrile, methoxyacetonitrile, propionitrile, 3-methoxypropionitrile (MePN) and benzonitrile; carbonates such as ethylene carbonate (EC), propylene carbonate (PC); heterocyclic compounds such as 3-methyl-2-oxazolidinone, N-methylpyrrolidone (NMP) and γ-butyrolactone (GBL); ethers such as dioxane and diethyl ether; chain ethers such as ethylene glycol dialkylether, propylene glycol dialkylether, polyethylene glycol dialkylether and polypropylene glycol dialkylether; monoalcohols such as methanol, ethanol, ethylene glycol monoalkylether and propylene glycol monoalkylether; polyalcohols such as ethylene glycol, propylene glycol, polyethylene glycol, polypropylene glycol and glycerine; aprotic solvents such as dimethylsulfoxide and sulfolane. These organic solvents may be used either alone or in combination thereof. In another particular embodiment, the solvent is water.

Alternatively, ionic liquids, preferably room-temperature ionic liquids, can be used in liquid electrolytes as both the source of redox couple and the organic solvent itself.

Non-limiting examples of ionic liquids suitable in the present invention are methyl-hexyl-imidazolium iodide (MHIMI), methyl-hexyl-imidazolium chloride (MHIMCI), 1-ethyl-3-methylimidazolium iodide (EMIMI), ethyl-3-methylimidazolium chloride (EMIMCI), ethyl-3-methylimidazolium dicyanamide, 1-butyl-3-methylimidazolium iodide (BMIMI) and 1-butyl-3,5-dimethylpyridinium bromide.

In addition, the liquid electrolyte may further comprise an electric additive for optimizing the photovoltaic performance of the cell.

Non-limiting examples of electric additives suitable in the present invention are nitrogen-containing heterocyclic compounds such as pyridine, 4-tert-butylpyridine, guanidinium thiocyanate (GuNCS), lithium salts, 4-tert-butylpyridine (TBP) and N-methylbenzimidazole (NMBI).

In the context of the present invention, the term "solid electrolyte" refers to electrolytes which use hole transport materials (HTMs) as medium or to a solid-state electrolyte containing a redox couple as medium.

Non-limiting examples of HTMs suitable in the present invention are inorganic compounds based on copper such as CuI, CuBr or CuSCN and organic compounds such as 2,2',7,7'-tetrakis(N,N-di-p-methoxyphenyl-amine)9,9'-spirobifluorene (OMeTAD).

A non-limiting example of a solid-state electrolyte containing a redox couple as medium suitable in the present invention is the system formed by LiIC₆H₁₀N₂O₂[LiI(HPN)₂] single crystal and iodide/tri-iodide.

In the context of the present invention, the term "quasi-solid electrolyte" or "gel electrolyte" refers to a system which consists of a polymer network (polymer host) swollen with liquid electrolytes.

Non-limiting examples of quasi-solid electrolytes suitable in the present invention are thermoplastic gel electrolytes (TPGEs) and thermosetting gel electrolytes (TSGEs).

In a preferred embodiment, the electrolyte is a liquid electrolyte comprising a redox couple and an organic solvent. More preferably, the liquid electrolyte comprises the redox couple I⁻/I₂ and an organic solvent. Said redox couple gives rise spontaneously to I₃⁻ upon mixture of iodide (I⁻) and I₂. Even more preferably, in the redox couple I⁻/I₂, the iodine anion is a quaternary ammonium iodide such as tetralkylammonium iodide, pyridinium iodide or imidazolium iodide. Most preferably the redox couple I⁻/I₂ consists of a mixture of 1-butyl-3-methylimidazolium iodide and I₂.

In another particular embodiment, the organic solvent is a nitrile, more preferably acetonitrile, valeronitrile and mixtures thereof.

For example, an electrolyte solution comprising 1-butyl-3-methylimidazolium iodide, I₂, guanidinium thiocyanate, and 4-tert-butylpyridine in a mixture of acetonitrile/valeronitrile can be used in the present invention. More preferably, an electrolyte solution comprising 0.6 M 1-butyl-3-methylimidazolium iodide, 0.05 M I₂, 0.1 M guanidinium thiocyanate, and 0.5 M 4-tert-butylpyridine in a mixture of acetonitrile/valeronitrile (85:15, v/v) can be used in the present invention.

In another aspect, the present invention is directed to a method 1 for the preparation of the membrane as defined above, comprising the steps of:
a) providing porous carbon nanotube-based fibers;
b) converting the porous carbon nanotube-based fibers into a membrane;
c) immersing said membrane into an electrolyte solution so as the electrolyte is confined within the pores of the porous carbon nanotube-based fibers.

In step (a) of the method 1 of the invention, the carbon nanotube-based fibers are preferably prepared by direct spinning from the gas-phase. A suitable method for the synthesis of the carbon nanotube fibers is described in the patent documents EP2615193B1, EP2631330B1 and EP2631331A1.

In a particular embodiment, said preparation method starts from a carbon nanotube precursor solution, wherein said solution contains a mixture of reagents consisting of ethanol or butanol that acts as carbon precursor or carbon source for the production of the nanotubes, a sulfur compound that acts as a promoter of the reaction, for example thiophene, and an iron compound which acts as a precursor for the formation of iron as a catalyst, for example ferrocene. As a preliminary step, the solution can be subjected to magnetic stirring and ultrasonication. The solution with these three components is injected into a pre-heater where the mixture is evaporated and then transferred to a reactor operating at a temperature of between 1000 and 1400°C. In addition to the mixture, a stream of hydrogen is injected into the reactor. Inside the reactor the reaction between the components of the initial mixture takes place, so that an aerogel of carbon nanotubes is generated. At the bottom of the reactor, a rod is introduced which causes agglomeration of said aerogel of carbon nanotubes at the same time as said agglomerate is adhered to the rod and is extracted from the reactor in the form of a fiber. As the formed fiber is extracted, it is collected onto a substrate. The method allows obtaining a fiber with a long length in a short period of time.

Step (b) of the process 1 of the invention allows the porous carbon nanotube-based fibers obtained in step (a) to be processed in the form of a membrane. In a particular embodiment, the membrane is prepared by winding multiple porous carbon nanotube-based fibers onto a rotatory bobbin under transverse motion. The membrane is optionally consolidated by densification with an organic solvent, such as acetone, and dried at room temperature.

Membranes of a specific geometry or configuration can be produced by filament winding whereby the carbon nanotube-based fibers are collected onto a pre-form of the desired geometry. This can also be done while the electrolyte is simultaneously integrated into the carbon nanotube-based fibers pore structure.

Non-limiting examples of geometries suitable for the membrane of the present invention are planar with or without curvature, cylindrical, spiral or of irregular cross-section.

In addition, the method 1 for the preparation of the membrane as defined above further comprises the step (c) of immersing the membrane into an electrolyte solution in order for the electrolyte to infiltrate within the pores of the carbon nanotube-based fibers.

The infiltration of the electrolyte solution within the pores of the carbon nanotube-based fibers can be achieved by a continuous process, for example, by dip-coating and/or spray-coating.

In the method 1 of the invention, the electrolyte solution is prepared by adding the electrolyte as defined above into a suitable solvent or a suitable mixture of solvents.

Any of the electrolytes mentioned above can be used in the method 1 of the invention.

In a preferred embodiment, the electrolyte solution comprises a redox couple and an organic solvent. More preferably, the liquid electrolyte comprises the redox couple I⁻/I₂ and an organic solvent. Even more preferably, in the redox couple I⁻/I₂, the iodine anion is a quaternary ammonium iodide such as tetralkylammonium iodide, pyridinium iodide or imidazolium iodide. Most preferably the redox couple I⁻/I₂ consists of a mixture of 1-butyl-3-methylimidazolium iodide and I₂.

In another particular embodiment, the organic solvent is a nitrile, more preferably acetonitrile, valeronitrile and mixtures thereof.

For example, an electrolyte solution comprising 1-butyl-3-methylimidazolium iodide, I₂, guanidinium thiocyanate, and 4-tert-butylpyridine in a mixture of acetonitrile/valeronitrile can be used in the method 1 of the present invention. More preferably, an electrolyte solution comprising 0.6 M 1-butyl-3-methylimidazolium iodide, 0.05 M I₂, 0.1 M guanidinium thiocyanate, and 0.5 M 4-tert-butylpyridine in a mixture of acetonitrile/valeronitrile (85:15, v/v) can be used in the method 1 of the invention.

In another preferred embodiment, steps (b) and (c) can be performed simultaneously, *i.e.,* the carbon nanotube fibers are in situ immersed within the electrolyte solution during the membrane production.

In a preferred embodiment, the method 1 of the present invention further comprises the step (d) of drying the membrane.

In another aspect, the present invention is directed to a dye-sensitized solar cell comprising at least one membrane as defined above.

As mentioned above, Figure 1 shows a dye-sensitized solar cell according to the present invention. In a particular embodiment, said dye-sensitized solar cell comprises:
a) a transparent conductive substrate (1);
b) a mesoporous semiconductor layer (2) provided on the transparent substrate (1) and comprising a dye sensitizer; and
c) a membrane (3) as defined above, *i.e.,* a membrane comprising a porous carbon nanotube-based fibers and an electrolyte confined within the pores of said fibers, said membrane placed on the mesoporous semiconductor layer (2).

For the transparent conductive substrate (1), any material having conductivity and transparency may be used without limitation. In a particular embodiment, it contains a conductive material (1b) selected from the group consisting of an indium tin oxide (ITO), a fluorine tin oxide (FTO), ZnO-Ga₂O₃, ZnO-Al₂O₃, a tin-based oxide, a zinc oxide, a network of nanocarbons and combinations thereof. The preferred materials are indium tin oxide (ITO), a fluorine tin oxide (FTO) or combinations thereof due to cost reduction and excellent transparency and heat resistance.

This transparent conductive substrate acts as a front-electrode in dye-sensitized solar cell.

In order to maintain a certain mechanical integrity, the conductive material is preferably provided on a substrate (1 a) that is transparent to visible light. As for this substrate, for example, a glass substrate, a transparent plastic substrate or a ceramic substrate is used. The thickness of this substrate is not particularly limited as long as the substrate has appropriate mechanical properties and transparency which are permitted for the solar cell. Examples of the glass comprise soda glass, borosilicate glass, aluminosilicate glass, aluminoborosilicate glass, silica glass, soda lime glass, and the like. Examples of the plastic substrate include polyester sheet such as polyethylene terephthalate and polyethylene naphthalate, and sheet such as polyphenylene sulfide, polycarbonate, polysulfone, and polyethylidene norbornene. Examples of the ceramic substrate comprise high-purity alumina, and the like. Among the examples of the substrate, the glass substrate is preferred due to stability and operability.

The transparent conductive substrate may be doped with a metal selected from the group consisting of Group III metals, e.g., Al, Ga, In, Ti and combinations thereof.

The mesoporous semiconductor layer (2) may comprise a semiconductor material which is generally used in photoelectric conversion.

By the term "mesoporous semiconductor layer" should be understood a semiconductor layer containing pores with diameters between 2 and 100 nm.

Examples of the semiconductor material for the mesoporous semiconductor layer comprise titanium oxide, zinc oxide, tin oxide, niobium oxide, zirconium oxide, cerium oxide, tungsten oxide, silicon oxide, aluminum oxide, nickel oxide, tantalum oxide, barium titanate, strontium titanate, calcium titanate, zinc sulfide, lead sulfide, bismuth sulfide, cadmium sulfide, CuAlO₂, SrCu₂O₂, TiSrO₃ and the like. These materials may be used alone or in combination thereof. The mesoporous semiconductor layer may have a form of particle, rod, tube, wire, needle, film or combinations thereof.

Among the aforementioned examples of the semiconductor material, titanium oxide is preferred due to stability and safety. Examples of the titanium oxide include anatase type titanium oxide, rutile type titanium oxide, amorphous titanium oxide, metatitanic acid, orthotitanic acid, titanium hydroxide, hydrated titanium oxide, and the like.

The thickness of the mesoporous semiconductor layer (2) is not particularly limited, and may be controlled to 0.1 µm to 100 µm, particularly from 1 µm to 75 µm, more particularly from 1 to 20 µm.

The mesoporous semiconductor layer also comprises a dye-sensitizer which harvests light and transfers electric charge upon its oxidation. This dye-sensitized is generally absorbed in the mesoporous semiconductor layer. The dye-sensitizer may be a dye-sensitizer having an absorbance in a wide range of a visible light region and/or an IR region, and may be, for example, an organic dye, a metal complex dye, inorganic and/or organic quantum dot, perovskites and the like.

Examples of organic dyes include azo type dyes, quinone type dyes, quinone-imine type dyes, quinacridone type dyes, squarylium type dyes, cyanide type dyes, type dyes merocyanine, triphenylmethane type dyes, xanthene type dyes, porphyrin type dyes, perylene type dyes, indigo type dyes, and naphthalocyanine type dyes. Examples of the metal complex dyes include phtalocyanine type dyes, and ruthenium type dyes, comprising as a dominant metal, a metal such as Cu, Ni, Fe, Co, V, Sn, Si, Ti, Ge, Cr, Zn, Ru, Mg, Al, Pb, Mn, In, Mo, Y, Zr, Nb, Sb, La, W, Pt, Ta, Ir, Pd, Os, Ga, Tb, Eu, Rb, Bi, Se, As, Sc, Ag, Cd, Hf, Re, Au, Ac, Tc, Te and Rh.

Example of quantum dot dyes include lead sulphide (PbS), zinc sulphide (ZnS), cadmium sulphide (CdS), cadmium selenide (CdSe), cadmium telluride (CdTe), silver (Ag), gold (Au), aluminium (Al), or mixture thereof.

The perovskite may have a formula AMX₃, wherein A is an organic cation or alkali metal, M is a metal and X is a halide.

In a particular embodiment, A is an organic cation. More particularly, A is selected from the following:
- a primary, secondary or tertiary ammonium ion, where the substituents of nitrogen are aryl or alkyl groups;
- a compound of formula: , 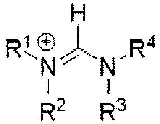 where R¹, R², R³, and R⁴ are independently hydrogen, an alkyl or aryl group;
- a compound of formula: 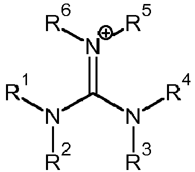 wherein R¹, R², R³, R⁴ and R⁵ are independtly hydrogen, an alkyl or aryl group.

In the context of the present invention, the alkyl group refers to a linear or branched hydrocarbon chain having from 1 to 6 carbon atoms, preferably 1 to 3 carbon atoms, containing no insaturation, and which is attached to the nitrogen atom by a single bond, e. g., methyl, ethyl, n-propyl, i-propyl, n-butyl, t-butyl, n-pentyl, etc.

The term aryl group refers to an aromatic ring system comprising from 6 to 14 carbon atoms, more particularly 6 to 10, even more particularly 6 carbon atoms. According to an embodiment, aryl is a phenyl, naphthyl, indenyl, fenanthryl or anthracyl radical, preferably phenyl or naphthyl radical.

In a preferred embodiment, A is a guanidinium cation.

In another particular embodiment, A is a monovalent alkali metal ion, such as Cs⁺ or Rb⁺.

In another particular embodiment, M is any divalent metal ion such as Sn²⁺, Pb²⁺ or Ge²⁺.

In another particular embodiment, X is a halide such as Cl⁻, Br⁻, I⁻ or F⁻.

The perovskite may also have the formula A₁₋ₓBₓMX₃, wherein A and B are any of the two different cations (organic and monovalent alkali metal) described above; M and X are also as described above and x is from 0 to 1.

The perovskite may also have the formula AMX_{3-z}Y_{z}, wherein A is an organic cation or alkali metal as defined above, M is a divalent metal, X and Y are different halides as described above and z is from 0 to 3.

The perovskite may also have the formula AM_{1-y}N_{y}X₃, wherein wherein A is an organic cation or alkali metal as defined above, M and N are different divalent metal ions as described above, X is an halide as defined above, and y is from 0 to 1.

The perovskite may also be a combination of all the above, i.e. that having a formula A₁₋ₓBₓM_{1-y}N_{y}X_{3-z}Y_{z} wherein A and B are any two different cations described above, x is from 0 to 1, X and Y are different halides as described above, z is from 0 to 3, M and N are different divalent metal ions as described above and y is from 0 to 1.

In a preferred embodiment, the dye-sensitizer is a ruthenium complex dye, such as cis-diisothiocyanato-bis(2,2'-bipyridyl-4,4'-dicarboxylato) ruthenium(II) bis(tetrabutylammonium).

Further, it is preferred that the dye-sensitizer comprise a functional group for bonding to the mesoporous semiconductor layer (2). Examples of the functional groups comprise carbonyl, alkoxy, hydroxyl, sulfonic acid, ester, mercapto or a phosphonyl group.

In order to extend a photoelectric conversion wavelength range of the dye sensitizer and thereby improving photoelectric conversion efficiency, two or more kinds of sensitizing dye compounds having different photoelectric conversion wavelength ranges may be used in combination. In this case, it is possible to select and apply the types and ratio of the dye sensitizer compounds according to the wavelength range and intensity distribution of irradiated light.

The mesoporous semiconductor layer comprising the dye-sensitizer constitutes the "photo-anode" of the dye-sensitizer solar cell.

The dye-sensitized solar cell of the present invention also comprises at least one membrane (3) as defined above.

As explained above, the membrane of the present invention (3), when integrated in a dye-sensitized solar cell, allows significant reduction of the number of components.

In addition, the membrane of the present invention (3), when integrated in a dye-sensitized solar cell, allows significant simplification of the cell fabrication process.

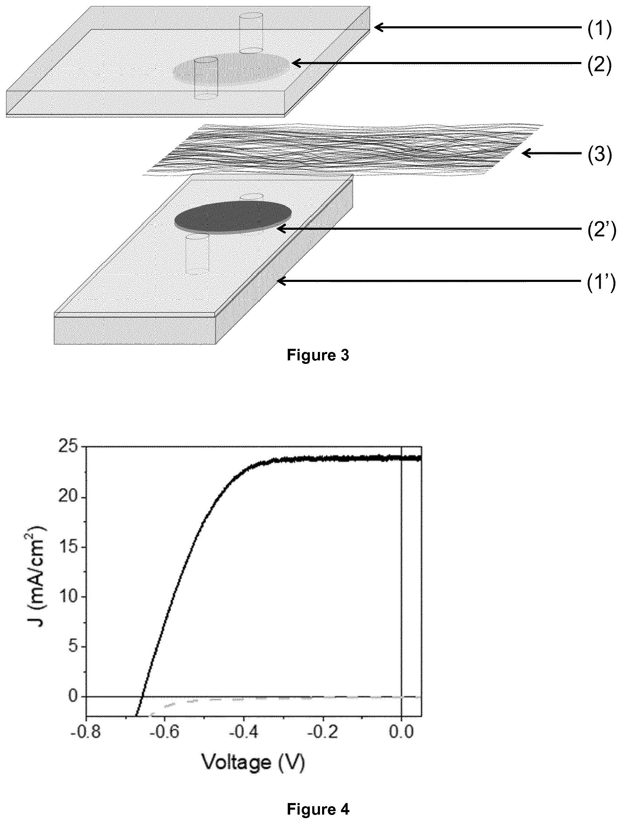

In a particular embodiment of the present invention, the dye-sensitized solar cell comprises an additional mesoporous semiconductor layer comprising a dye-sensitizer, i.e., the dye-sensitized solar cell includes two photo-anodes, as well as a further transparent conductive substrate, as shown in Figure 3.

In this particular embodiment, the dye-sensitized solar cell comprises:
a) a first transparent conductive substrate (1);
b) a first mesoporous semiconductor layer (2) provided on the first transparent substrate (1) and comprising a dye sensitizer;
c) a membrane (3) as defined above, *i.e.,* a membrane comprising a porous carbon nanotube-based fibers and an electrolyte confined within the pores of said fibers, said membrane placed on the mesoporous semiconductor layer (2);
d) a second mesoporous semiconductor layer (2') provided on the membrane (3), and comprising a dye sensitizer;
e) a second transparent conductive substrate (1') provided on the second mesoporous semiconductor layer (2').

Both, the second mesoporous semiconductor layer (2') and the second transparent conductive substrate (1') may be made of any of the materials mentioned above for the mesoporous semiconductor layer (2) and for the transparent conductive substrate (1), respectively.

Thus, this particular dye-sensitized solar cell comprises two photoanodes and a single counter-electrode acting as unipolar plate sandwhiched between them, as well as current collector. Furthermore, this particular design enables harvesting of solar energy from multiple irradiation points.

Another object of the present invention provides a method (method 2) of preparing a dye-sensitized solar cell as described above comprising the steps of:
a) providing a transparent conductive substrate (1);
b) forming a mesoporous semiconductor layer (2) on the transparent conductive substrate (1);
c) adsorbing a dye sensitizer in the mesoporous semiconductor layer (2);
d) depositing a membrane (3) comprising a porous carbon nanotube-based fibers and an electrolyte confined within the pores of said fibers, on the mesoporous semiconductor layer (2).

In step (a) it is provided a transparent conductive substrate (1). This comprises a conductive material (1b), such as those defined above. In a particular embodiment, it contains a conductive material selected from the group consisting of an indium tin oxide (ITO), a fluorine tin oxide (FTO), ZnO-Ga₂O₃, ZnO-Al₂O₃, a tin-based oxide, a zinc oxide and combinations thereof. The preferred materials are indium tin oxide (ITO), a fluorine tin oxide (FTO) or combinations thereof due to cost reduction and excellent transparency and heat resistance.

The conductive material is preferably provided on a substrate or plate (1a) that is transparent to visible light. As for this substrate, for example, a glass substrate, a transparent plastic substrate or a ceramic substrate is used, such as those described above.

In a particular embodiment, the conductive material (1b) is first sintered and then placed on the substrate or plate (1a) that is transparent to visible light.

Before forming the mesomesoporous semiconductor layer (2) on the transparent conductive substrate (1) in step (b), it is possible to perform pre-treatments that reinforce bonding strength, such as semiconductor layer material pre-treatment using a semiconductor material precursor solution, plasma treatment, ozone treatment, and chemical treatment. As a result of the semiconductor material pre-treatment, a pre-treatment layer (semiconductor thin film) is formed on the transparent conductive substrate (1). It is preferred that the thickness of the pre-treatment layer is 0.1 to 50 nm, particularly from 0.2 to 25 nm.

Said pre-treatment can be made before or after placing the conductive material (1 b) on the substrate or plate (1a) that is transparent to visible light. More preferably, said pre-treatment is made before placing the conductive material (1 b) on the substrate or plate (1 a) that is transparent to visible light.

The mesomesoporous semiconductor layer (2) is formed on the transparent conductive substrate (1) or the pre-treatment layer in step (b). The fabrication method of the mesoporous semiconductor layer (2) is not particularly limited. For example, the mesoporous semiconductor layer (2) may be fabricated by applying a paste comprising a semiconductor material (such as those described above) having a form of particle (nanoparticle, nanocrystal), rod, tube, wire or needle on the transparent conductive substrate, and then sintering the paste. The paste can be applied by a screen printing process, a doctor blade process, a squeegee process, a spin-coat process, an inkjet printing process, a gravure coat process, a chemical vapor deposition (CVD) method, a metal-organic chemical vapor deposition (MOCVD), a physical vapor deposition (PVD), a sputtering method, a sol-gel method, and the like. The mesoporous semiconductor layer (2) may also be formed by transferring an alignment layer onto the transparent conductive substrate (1) with a semiconductor material having a form of a rod, tube, wire or needle.

In a preferred embodiment, the mesomesoporous semiconductor layer (2) is subjected to a heat treatment in order to remove any solvent and organic material and to increase the connectivity between particles, rods, tubes, wires or needles conforming the semiconductor material. Said heat treatment also increases the adhesion between the mesoporous semiconductor layer (2) and the transparent conductive substrate (1). The temperature and time of the heat treatment are not particularly limited. In a particular embodiment, the temperature is controlled to be from 30 to 700°C, more particularly from 60 to 600°C, and the time is controlled to be from 5 minutes to 10 hours, more particularly from 10 minutes to 6 hours. Said heat treatment can be made in one step or in several steps using different temperature ranges.

In step (c) of the process 2 of the invention, the dye sensitizer is adsorbed in the mesoporous semiconductor layer. In a preferred embodiment, the mesoporous semiconductor layer (2) formed on the transparent conductive substrate (1) is immersed into a solution comprising the dye sensitizer. The solution comprising the dye sensitizer may be permeated into the mesoporous semiconductor layer (2). The solution is not particularly limited as long as the dye sensitizer may be dissolved therein. Examples of the solution comprise organic solvents such as alcohols, toluene, acetonitrile, chloroform, dimethylformamide or mixtures thereof.

In a preferred embodiment, the solution comprises cis-diisothiocyanato-bis(2,2'-bipyridyl-4,4'-dicarboxylato) ruthenium(II) bis(tetrabutyl-ammonium) as the dye sensitizer and a mixture of acetonitrile and tert-butyl alcohol as the organic solvent.

The immersion step may be performed once or a plurality of times.

In a preferred embodiment, after the mesomesoporous semiconductor layer (2) is formed on the transparent conductive substrate and the dye is adsorbed in the mesomesoporous semiconductor layer, a heat treatment may be carried out. Said heat treatment can be made at from about 40°C to about 300°C, preferably from 70°C to 120°C.

In step (d) of the method 2 of the invention the membrane (3), previously formed according to the method 1 of the invention, can be placed in contact with the mesomesoporous semiconductor layer (2), for example, by simply pressing the membrane (3) against the mesomesoporous semiconductor layer (2).

The press treatment is not particularly limited and examples thereof include press molding using a plate and roll pressing using a roller. Heat may be applied during the press treatment. Moreover, a releasing material may be provided between the press and the membrane.

In a preferred embodiment, the transparent conductive substrate (1), the mesoporous semiconductor layer (2) comprising the dye-sensitizer, and the carbon nanotube-based membrane (3) can be assembled into a sealed sandwich-type by heating at a temperature between 100 and 150°C with a controlled pressure using a hot-melt sealing film and a top Teflon substrate that can be easily removed after pressing.

Optionally, additional electrolyte solution can be dropped onto the membrane (3) to ensure its saturation.

In a preferred embodiment, the method 2 as defined above further comprises the use of a sealant in order to ensure the assembling of the membrane (3) with the mesoporous semiconductor layer (2).

In another preferred embodiment, when the dye-sensitizer solar cell includes two mesoporous semiconductor layers (2) and (2') and two transparent conductive substrates (1) and (1'), the membrane (3) is placed between the two mesoporous conductor layers (2) and (2') and all the components can also be assembled into a sealed sandwich-type by heating at a temperature between 100 and 150°C with a controlled pressure using a hot-melt sealing film and a top Teflon substrate that can be easily removed after pressing.

Thus, in a particular embodiment, the method 2 of the present invention comprises:
a) providing a firs transparent conductive substrate (1) and a second transparent conductive substrate (1');
b) forming a first mesoporous semiconductor layer (2) on the first transparent conductive substrate (1) and forming a second mesoporous semiconductor layer (2') on the second transparent conductive substrate (1');
c) adsorbing a dye sensitizer in the first semiconductor layer (2) and in the second semiconductor layer (2');
d) depositing a membrane (3) comprising a porous carbon nanotube-based fibers and an electrolyte confined within the pores of said fibers, between the first mesoporous semiconductor layer (2) and the second mesoporous semiconductor layer (2').

Thus, the use of the membrane of the present invention integrated in a dye-sensitized solar cell eliminates the need for several steps in the traditional DSSCs fabrication process, in particular, eliminates at least the need for Pt deposition onto the current-collector and the injection of the electrolyte into the cell.

These improvements to the fabrication process are achieved while also providing improvements in performance of the cell, in particular, reduction of the distance between electrodes, which increases solar conversion efficiency, avoid electrolyte leakage and thus increasing the lifetime of the solar cell, and cost reduction through elimination of the Pt and traditional expensive (for example, ITO) current collector.

The dye-sensitized solar cell of the present invention presents high efficiency compared to state-of-the-art DSSCs. The efficiency of a solar cell is the most commonly used parameter to compare the performance of one solar cell to another. Efficiency is defined as the ratio of energy output from the solar cell to input energy from the sun. In addition the performance of the solar cell and its efficiency depend on the spectrum and intensity of the incident sunlight and the temperature of the solar cell.

Therefore, the dye-sensitized solar cell of the present invention can present efficiency close to 9 % that is higher than the previous art in DSSCs with carbon nanotube fiber counter-electrodes using standard device architecture and it is also comparable with those noted for the best Pt-based DSSCs.

Thus, still another aspect of the present invention refers to the use of the dye-sensitized solar cell as defined above for converting solar energy into electric energy.

The conversion of solar energy into electric energy may take place as follows: sunlight enters the cell through the transparent conductor substrate (front-electrode), exciting the dye on the surface of the mesoporous semiconductor layer. Photons absorbed by the dye create an excited state of the dye, from which an electron can be "injected" directly into the conduction band of the conductive material constituting the mesomesoporous semiconductor layer. From there, it moves by diffusion (as a result of an electron concentration gradient) to the conductive substrate (1). Meanwhile, the oxidized dye will decompose if another electron is not provided. The dye strips one from, for example, iodide present in electrolyte oxidizing it into triiodide. This reaction occurs quite quickly compared to the time that it takes for the injected electron to recombine with the oxidized dye, preventing this recombination reaction that effectively reduces the photogenerated current. The triiodide then recovers its missing electron by mechanically diffusing to the the counter electrode re-introduces the electrons after flowing through the external circuit.

### Examples

### Example 1 - Device fabrication

A fluorine-doped tin oxide (FTO) substrate was sonicated with a detergent solution, deionized water, and isopropyl alcohol. FTO substrate was immersed into a 40 mM aqueous TiCl₄ solution at 70°C for 30 min and washed with water and ethanol followed by a sintering at 450°C for 30 min (1). Then, the transparent nano-crystalline TiO₂ layer (2), made of Ti-Nanoxide T/SP, Solaronix, was deposited and heated under air flow at 125°C for 6 min, 325°C held for 5 min, 375°C held for 5 min, heated to 450°C held for 30 min, and finally sintered at 500°C for 15 min. The sintered films were immersed overnight into a 0.5 mM solution of cis-diisothiocyanato-bis(2,2'-bipyridyl-4,4'-dicarboxylato) ruthenium(II) bis(tetrabutyl-ammonium) (N719) in ACN/tert-butyl alcohol (50:50 vol%) acting as dye.

Carbon nanotube-based fibers were synthesized by the direct spinning method, which involves the continuous withdrawal of a Carbon nanotube-based aerogel directly from the gas-phase during growth of Carbon nanotubes by floating catalyst chemical vapor deposition (EP2615193B1, EP2631330B1 y EP2631331A1), using ferrocene as iron catalyst, thiophene as a sulfur catalyst promoter and butanol as carbon source. The reaction was carried out in hydrogen atmosphere at 1250°C, using a S/C ratio to produce fibers predominantly made up of muti-walled carbon nanotubes of few-layers. A carbon nanotube-based membrane (3) was prepared by winding multiple carbon nanotube-based fibers onto a rotating bobbin under transverse motion. The resulting porous sheet was optionally consolidated by densification with acetone and dried at room temperature.

Then, the membrane (3) was produced by immersing the porous sheet into an electrolyte solution comprising 0.6 M 1-butyl-3-methylimidazolium iodide, 0.05 M I₂, 0.1 M guanidinium thiocyanate and 0.5 M 4-tert-butylpyridine in a mixture of acetonitrile/valeronitrile (85:15, v/v).

In Figure 1, the TiO₂ layer (2) bearing the ruthenium complex as dye-sensitizer and the carbon nanotube-based membrane (3) were assembled into a sealed sandwich-type DSSC by heating at 120°C with a controlled pressure using a hot-melt sealing film and a top Teflon substrate that was easily removed after pressing. Afterwards, additional electrolyte solution was dropped onto the membrane to ensure its saturation.

In Figure 3, the two TiO₂ layers (2) and (2') bearing the ruthenium complex as dye-sensitizer, and the carbon nanotube-based membrane (3) were assembled into a sealed sandwich-type DSSC by heating at 120°C with a controlled pressure using a hot-melt sealing film placed at the borders to keep the cell close.

### Example 2 - Measuring set-up

Photo-current measurements were performed using a 150 W lamp (Xe-arc lamp (Newport/Oriel, model 66475-150XV-R22) modified with an AM 1.5 G filter of Newport and calibrated to 1000 W m⁻² under AM 1.5G conditions with a Si-Reference cell (Newport/Oriel, Model 91150V). Current-voltage measurements were measured by using a potentiostat/galvanostat (PGSTAT30N, Autolab) in the range of -0.9 to 0.2 V with a scan rate of 100mV/s. DSSC were measured by using a shading mask with an aperture size according to the literature.

### Example 3 - Performance of the carbon nanotube membrane DSSCs compared to those with Pt-based counter-electrodes.

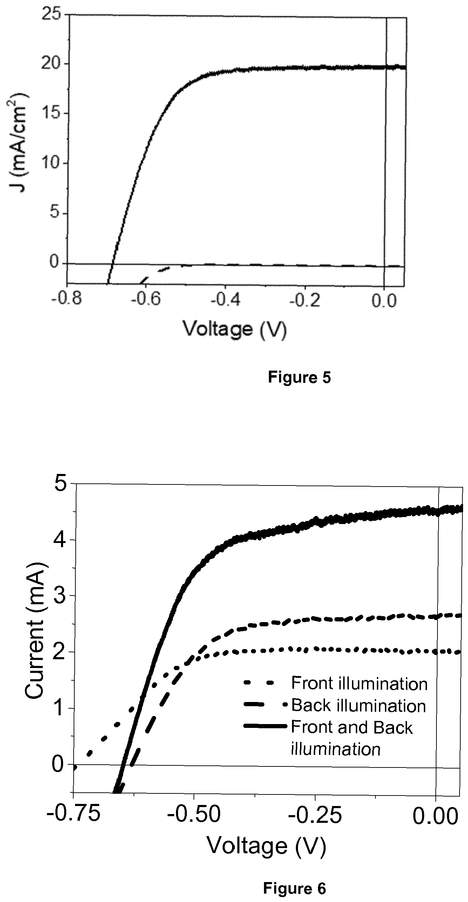

Figure 4 presents a plot showing the performance of the DSSCs manufactured according to example 1 and Figure 1. Here, the device behavior is similar to that of Pt-based DSSCs upon increasing the thickness of the photoanode (Figure 5). This indicates that the CNT membrane can be considered as alternative of Pt-based counter electrodes.

Regardless of the device architecture, carbon nanotube membrane DSSCs outperform those with Pt counter electrodes - Figures 4 and 5. The maximum efficiency under standard conditions was 9.4 % and 9.1 % for the carbon nanotube membrane and Pt-based DSSCs, respectively.

### Example 4 - Performance of the carbon nanotube membrane DSSCs bearing two photoanodes

Figure 6 shows the performance of both photoanodes under illumination showing similar efficiencies. Upon simultaneous illumination of both photoanodes, the short circuit current represents the sum of each cell, indicating that the carbon nanotube membrane acts as unipolar counter-electrode as well as current collector.

## Claims

1. A membrane suitable for dye-sensitized solar cells comprising:
- porous carbon nanotube-based fibers, and
- an electrolyte confined within the pores of said fibers.

2. The carbon nanotube-based membrane according to claim 1, wherein the carbon nanotube-based fibers are fibers having a specific surface area between 50 and 2000 cm³/g.

3. The carbon nanotube-based membrane according to any of claims 1 to 2, wherein the electrolyte is an organic liquid electrolyte comprising a redox couple and a solvent.

4. The carbon nanotube-based membrane according to claim 3, wherein the redox couple is I⁻/I₂, being the iodine anion selected from a quaternary ammonium iodide, a pyridinium iodide and an imidazolium iodide; and the organic solvent is a nitrile.

5. The carbon nanotube-based membrane according to claim 4, wherein the redox couple is 1-butyl-3-methylimidazolium iodide/I₂, and the organic solvent is a mixture of acetonitrile and valeronitirle.

6. A method for the preparation of the membrane as defined in any of claims 1 to 5, comprising the steps of:
a) providing porous carbon nanotube-based fibers;
b) converting the porous carbon nanotube-based fibers into a membrane;
c) immersing said membrane into an electrolyte solution so as the electrolyte is confined within the pores of the porous carbon nanotube-based fibers.

7. The method according to claim 6, wherein the carbon nanotube-based fibers of step (a) are prepared by direct spinning from the gas-phase.

8. A dye-sensitized solar cell comprising at least one membrane according to any of claims 1 to 5.

9. The dye-sensitized solar cell according to claim 8 comprising:
- a transparent conductive substrate (1);
- a mesoporous semiconductor layer (2) provided on the transparent substrate (1) and comprising a dye sensitizer; and
- a membrane (3) as defined in any of claims 1 to 6, said membrane (3) placed on the mesoporous semiconductor layer (2).

10. The dye-sensitizer solar cell according to claim 9, wherein the transparent conductive substrate (1) comprises:
- a transparent conductive material (1 b) selected from indium tin oxide (ITO), a fluorine tin oxide (FTO) and combinations thereof; and
- a substrate or plate (1a) that is transparent to visible light.

11. The dye-sensitizer solar cell according to any of claims 9 to 10, wherein the mesoporous semiconductor layer (2) is a TiO₂ layer.

12. The dye-sensitizer solar cell according to any of claims 9 to 11, wherein the dye-sensitizer is a ruthenium complex dye.

13. The dye-sensitizer solar cell according to any of claims 9 to 12 which comprises:
a) a first transparent conductive substrate (1);
b) a first mesoporous semiconductor layer (2) provided on the first transparent substrate (1) and comprising a dye sensitizer;
c) a membrane (3) as defined in any of claims 1 to 6, said membrane (3) placed on the mesoporous semiconductor layer (2);
d) a second mesoporous semiconductor layer (2') provided on the membrane (3), and comprising a dye sensitizer;
e) a second transparent conductive substrate (1') provided on the second mesoporous semiconductor layer (2').

14. A method of preparing the dye-sensitized solar cell according to any of claims 9 to 12, comprising the steps of:
a) providing a transparent conductive substrate (1);
b) forming a mesoporous semiconductor layer (2) on the transparent conductive substrate (1);
c) adsorbing a dye sensitizer in the semiconductor layer (2);
d) depositing a membrane (3) comprising a porous carbon nanotube-based fibers and an electrolyte confined within the pores of said fibers, on the mesoporous semiconductor layer (2).

15. A method of preparing the dye-sensitized solar cell according to claim 13, comprising the steps of:
a) providing a firs transparent conductive substrate (1) and a second transparent conductive substrate (1');
b) forming a first mesoporous semiconductor layer (2) on the first transparent conductive substrate (1) and forming a second mesoporous semiconductor layer (2') on the second transparent conductive substrate (1');
c) adsorbing a dye sensitizer in the first semiconductor layer (2) and in the second semiconductor layer (2');
d) depositing a membrane (3) comprising a porous carbon nanotube-based fibers and an electrolyte confined within the pores of said fibers, between the first mesoporous semiconductor layer (2) and the second mesoporous semiconductor layer (2').
